# EUROPEAN PATENT SPECIFICATION

(11) **EP 1 023 821 B1**
(45) Date of publication and mention of the grant of the patent: **02.01.2002**
(21) Application number: 98945444.2
(22) Date of filing: 05.10.1998
(51) Int. Cl.: H05K 3/34, B23K 1/005

(54) **METHOD FOR CONNECTING SURFACE MOUNT COMPONENTS TO A SUBSTRATE**
VERFAHREN ZUR VERBINDUNG OBERFLÄCHENMONTIERTER BAUTEILE MIT EINEM SUBSTRAT
PROCEDE DE RACCORDEMENT A UN SUBSTRAT DE COMPOSANTS POUR MONTAGE EN SURFACE

(30) Priority: 06.10.1997 US 944428
(43) Date of publication of application: 02.08.2000
(73) Proprietor: FORD MOTOR COMPANY, Dearborn, MI 48121 (US); FORD MOTOR COMPANY LIMITED, Brentwood, Essex CM13 3BW (GB)
(72) Inventor: QUILTY, William, F., Jr., Levittown, PA 19057 (US); SINKUNAS, Peter, Joseph, Canton, MI 48187 (US); PARIKH, Mayank, Canton, MI 48187 (US); McLESKEY, Edward, P., Waterford, MI 48328 (US); LEMECHA, Myron, Dearborn, MI 48124 (US); GLOVATSKY, Andrew, Z., Livonia, MI 48150 (US); BAKER, Jay, DeAvis, Dearborn, MI 48121 (US)
(74) Representative: Messulam, Alec Moses
(86) International application number: GB9802981
(87) International publication number: WO9918762

(56) References cited:
- EP-A- 0 233 125
- DE-A- 2 735 231
- DE-A- 2 914 621
- DE-A- 4 405 784
- DE-A- 19 630 676

## Description

The present invention relates generally to surface mount components. More particularly, the present invention relates to a method for connecting surface mount components to a substrate.

Surface mount electronic components are typically attached to a printed circuit board (PCB) by a process of (1) applying solder paste to mounting pads on the PCB, (2) placing the components on the PCB such that the component terminations rest on their respective solder-pasted mounting pads, thereby forming a PCB assembly, and (3) sending the PCB assembly through a solder reflow oven. As a PCB assembly passes through the reflow oven, the solder paste depositions on the PCB are melted and allowed to reflow so that a molten solder joint is formed between each component termination and its associated mounting pad. Then, the reflow oven allows the molten joints to cool so that a solid solder joint is formed between each component termination and its respective mounting pad.

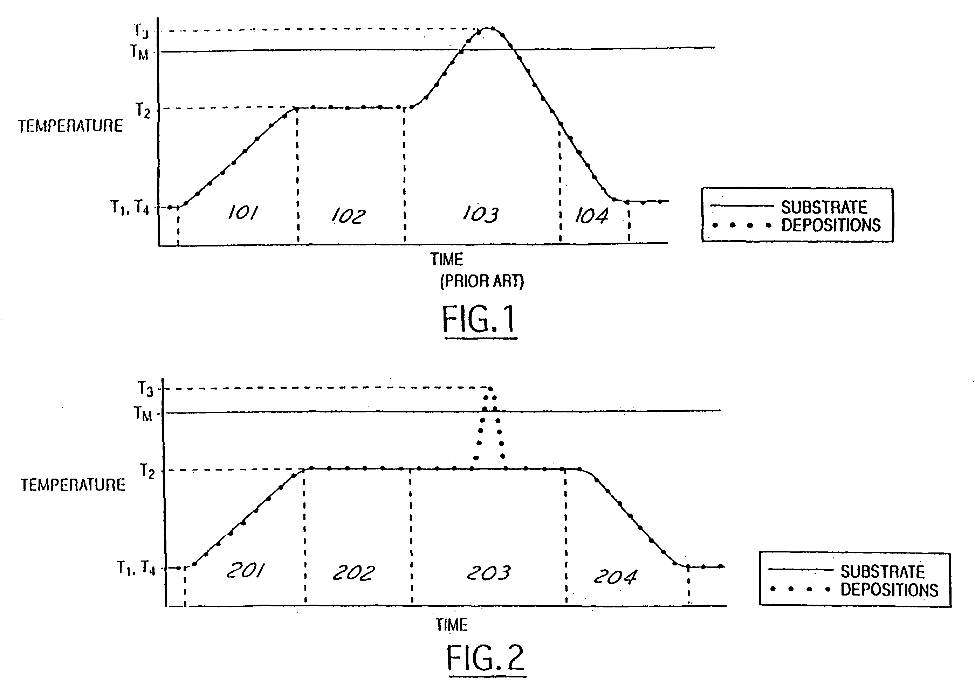

Conventional reflow ovens accomplish this process of melting, reflowing, and cooling by providing various temperature zones within the oven, each of which the PCB assembly is exposed to for a specified length.of time. This sequence of temperature zones and exposure times is referred to as a temperature-versus-time profile, or simply a temperature profile for short. Most reflow ovens can be programmed to provide a variety of temperature profiles in order to accommodate various combinations of substrate materials, solder paste formulations, component types and densities, etc. However, all conventional reflow ovens follow a basic temperature profile, as illustrated in FIG. 1.

This profile consists of four sequential temperature. zones. The first is a "preheat" zone 101, which brings the entire PCB assembly from some initial, lower temperature T₁ (usually ambient) to a second, elevated temperature T₂ lower than the melting point T_{M} of the solder paste. The second zone is an "equilibrium" or "soak" zone 102, in which the PCB assembly is held at essentially T₂ to assure that the entire assembly-i.e., substrate, components, and solder paste-is brought up to this temperature T₂. Next is the "reflow" zone 103, in which the temperature of the assembly is elevated to a temperature T₃ above the melting point T_{M} of the solder paste in order to melt and reflow the paste. Finally, the assembly is then sent through a "cool-down" zone 104 which gradually brings the assembly temperature down from T₃ to a fourth temperature T₄. This fourth temperature T₄ is below that of the second temperature T₂, and is usually about the same as the first temperature T₁ (i.e., typically ambient; see e.g. document DE-A-2 914 621). Note in FIG. 1 that the overall temperatures of the substrate and the solder depositions-represented by solid and dotted lines, respectively-are essentially the same at all points along the temperature profile.

This process of melting, reflowing; and cooling is acceptable when processing PCBs made of conventional substrate materials, such as FR-4 (glass-filled epoxy laminates), glass-filled PET (polyethylene terepthalate), glass-filled polyamide (e.g., Nylon-6), glass-filled polyetherimide, and flex circuit substrates made from high temperature materials such as polyimide. However, when a lower melting point substrate material is used (e.g., polypropylene, or non-glass-filled polyamide or PET), the reflow temperature T₃ to which the assembly would be subjected in a conventional reflow oven may be too high, causing unacceptable softening, melting, and/or thermal degradation of the substrate material.

It would be desirable, therefore, to provide a method for melting, reflowing, and cooling solder paste depositions on a PCB assembly so as to form a solid solder joint between each component termination and its associated mounting pad without having to subject the entire substrate to the high reflow zone temperatures of conventional reflow ovens.

The present invention overcomes the disadvantages of the prior art by providing a method according to claim 1 for connecting surface mount components to a substrate without subjecting the overall substrate to unacceptably high reflow zone temperatures. The method comprises the steps of: (1) providing an electronic assembly which includes solder paste depositions atop mounting pads on a substrate and at least one electronic component having terminations arranged such that each termination rests atop a respective mounting pad; (2) preheating the assembly from a first temperature to a second temperature below the melting point of the solder paste; (3) soaking the assembly at substantially the second temperature; (4) selectively heating each solder paste deposition to a third temperature above the melting point of the solder paste depositions while maintaining the substrate at substantially the second temperature; and (5) cooling the assembly to a fourth temperature below the second temperature. The method may also be practised using bonding compounds other than solder paste, such as thermal-curing, electrically conductive adhesive. An apparatus for carrying out this method is also provided, as defined in claim 16.

It is an advantage that the present invention provides a process and apparatus for forming electrically conductive bonding compound joints between component terminations and their respective substrate mounting pads without subjecting the whole PCB substrate to high reflow zone temperatures. This permits the use of low melting point substrate materials in the PCB assembly.

It is another advantage that the present invention may be used with both conventional and low melting point substrate materials.

It is a further advantage that a surface mount component may be connected to its associated substrate much quicker according to the present invention than according to conventional reflow oven processing.

These and other advantages, features and objects of the invention will become apparent from the drawings, detailed description and claims which follow.

The invention will now be described, by way of example, with reference to the accompanying drawings, in which:
FIG. 1 is a schematic diagram of a typical temperature profile within a conventional solder reflow oven;
FIG. 2 is a schematic diagram of a temperature profile for selectively reflowing bonding compound depositions according to the present invention;
FIGS. 3-4 are perspective views of heating energy being selectively applied to single and multiple bonding compound depositions, respectively, according to the present invention;
FIG. 5 is a schematic diagram of a typical temperature profile for conventional laser soldering; and
FIG. 6 is a schematic.diagram of an apparatus for selectively reflowing bonding compound depositions according to the present invention.

Referring now to the drawings, FIG. 2 shows a schematic representation of a specialised temperature profile for reflowing bonding compound depositions according to the present invention. The bonding compound used may be a solder having a melting point T_{M}, a thermal-cure electrically conductive adhesive having an activation point T_{M}, or the like. As in the prior art reflow process described above, the temperature profile of the present invention includes a pre-heat zone 201, an equilibrium zone 202, a reflow zone 203, and a cool-down zone 204. As in FIG. 1, the overall temperature of the substrate is denoted in FIG. 2 by a solid line, while that of the bonding compound depositions is denoted by a dotted line.

Note that the preheat, equilibrium, and cool-down zones of the present invention 201/202/204 are similar to those of the prior art 101/102/104. That is, both the conventional process and a process according to the present invention have: (1) a preheat zone 101/201 which elevates the temperature of the overall assembly from a first predetermined temperature T₁ (usually ambient, or about 25°C) to a second predetermined temperature T₂ below the melting/activation point T_{M} of the bonding compound; (2) a soak zone 102/202 wherein the temperature of the overall assembly is maintained at substantially the second temperature T₂; and, following the reflow zone 103/203, (3) a cool-down zone 104/204 wherein the temperature of the overall assembly is gradually reduced from the ending temperature of the reflow zone (typically T₂) down to a fourth predetermined temperature T₄ (usually the same as T₁ or ambient).

The conventional reflow process and that of the present invention also include a reflow zone 103/203 following the preheat and soak zones. However, the temperature profile of the present invention's reflow zone 203 differs markedly from that of the conventional reflow process 103. Note that whereas both the substrate and bonding compound depositions undergo a temperature increase from the second temperature T₂ to a third predetermined temperature T₃ above the melting/activation point T_{M} of the deposition material in the conventional process shown in FIG. 1, in the present invention only the depositions undergo a temperature increase from T₂ to T₃, while the overall substrate temperature remains at essentially its previous temperature T₂. This divergence between the substrate and deposition temperatures is caused by selective further heating of only the depositions.

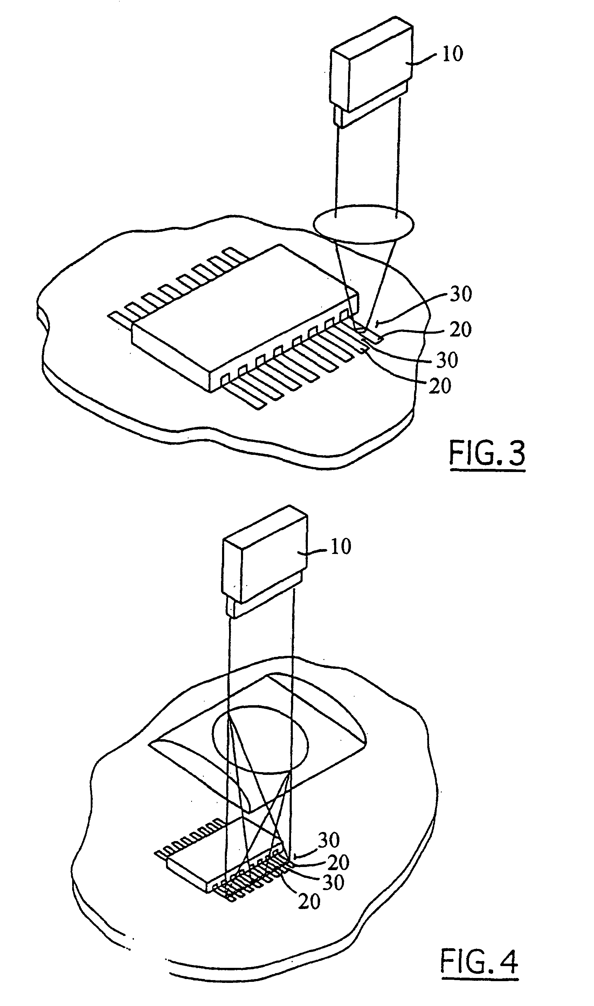

As illustrated by FIG. 2, the overall PCB assembly is maintained at essentially T₂ throughout the entire reflow process 203. This essentially constant heating may be provided, for example, by a modified conventional reflow oven, while the aforementioned selective heating of the bonding compound depositions (represented by the spiked, dotted line in zone 203) may be accomplished by such means as focusing a laser, xenon light, or other heating energy source 10 at one or more bonding compound depositions 20. (These depositions 20 may be heated directly, or indirectly by focusing the energy source 10 at the component terminations resting atop each deposition as shown in FIGS. 3-4.) Each beam of heating energy can be selectively directed at only one deposition, as shown in FIG. 3, or at several depositions at once, as shown in FIG. 4. In this way, essentially only the depositions are heated to T₃, causing the bonding compound to melt (if a solder) or activate (if a thermal-cure adhesive) without subjecting the entire substrate to the elevated reflow temperature T₃. This avoids raising the overall substrate temperature dangerously close to a critical temperature of the substrate material, thus allowing the use of low melting point substrate materials. Any peripheral areas 30 of the substrate immediately around or between the depositions 20 might also be incidentally or indirectly heated by the heating energy source 10, but even these small areas 30 are unlikely to be heated to T₃ or even to a critical temperature of the substrate. (As used here, "critical temperature" refers to a melting point, structural deformation point, or thermal degradation point of the substrate material.)

It should be noted that for the sake of simplicity, FIG. 2 shows only a single temperature burst in the reflow zone 203. This would be the profile if only one deposition were being reflowed using a single burst from the heating source 10, or if more than one deposition were being simultaneously reflowed using a single burst. In practice, however, a sequence of bursts would most likely be used during the reflow process 203 (i.e., one or more bursts for each single deposition or set of depositions).

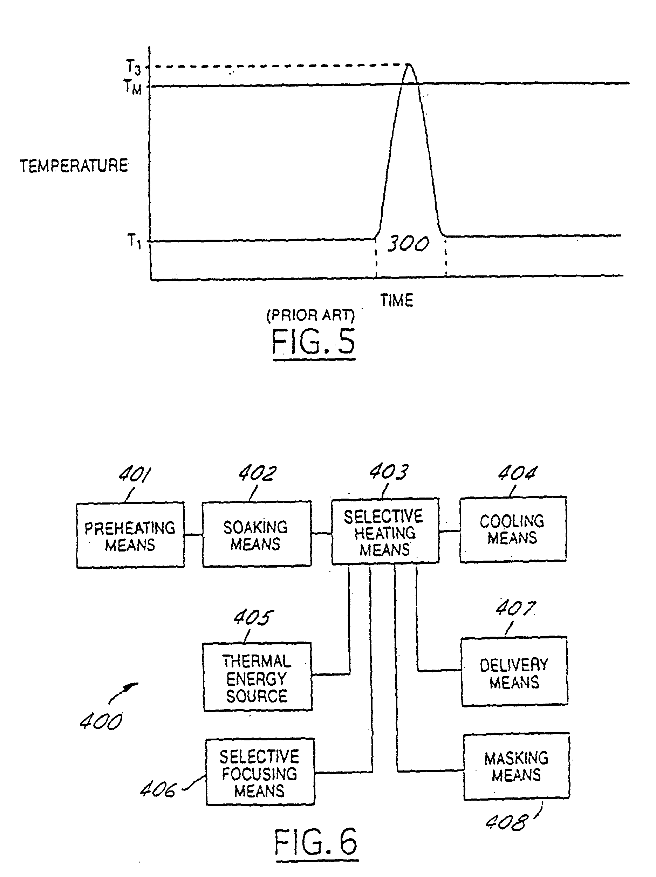

An apparatus 400 for providing the specialised temperature profile of the present invention is illustrated in FIG. 6, and includes: means 401 for preheating a PCB assembly from T₁ to T₂; means 402 for soaking the assembly at substantially T₂; means 403 for selectively heating each bonding compound deposition to T₃; and means 404 for cooling the assembly to T₄. (T₁ through T₄ have the same meaning here as above.) The preferred embodiment of such an apparatus 400 is a modified reflow oven wherein the means 401/402/404 for preheating, soaking, and cooling comprise the respective preheating, soaking, and cool-down portions of a conventional reflow oven. These portions are well known to those skilled in the art to which the present invention pertains.

The means 403 for selectively heating each deposition to T₃ comprises one or more non-contact thermal energy sources 405 arranged within a reflow zone section of the oven for providing the burst(s) of heating energy to each deposition. Means 403 may further include means 406. for selectively focusing and/or directing the heating energy from the heating source onto each deposition (such as mirrors, lenses, fibre optics, and/or other optical elements), means 407 for delivering the heating energy to each deposition in intermittent bursts (such as pulse/discharge control units), as well as means 408 for masking the PCB assembly (such as stencils or masks with apertures therein) so that substantially only one or more depositions at a time is/are exposed to the heating energy when the means for selective heating 403 is activated. Although various heating energy sources may be utilised, the preferred type of source is a laser, with a diode laser operating in the frequency range of 900 to 950 nm being the most preferred approach. This frequency range-which can typically be produced only by diode lasers-is preferred because within this range plastic substrates tend to absorb. less laser energy than at other frequencies, while absorption by metals (e.g., solder) remains relatively high.

This use of lasers to reflow bonding compound depositions may appear similar to conventional laser soldering, but is actually quite different. In conventional laser soldering, the entire PCB assembly (including its solder paste depositions) is typically provided at ambient temperature T₁; then, the laser energy directed at the solder paste depositions subjects the depositions to a sudden and steep temperature gradient from around ambient T₁ to a point T₃ above the melting point T_{M} of the solder paste-e.g., from about 25°C to about 220-280°C. Thus, as illustrated by region 300 in FIG. 5, a sudden reflow is performed, followed by an equally sudden, uncontrolled cool-down-no preheat, soak, or controlled cool-down are involved. In contrast, the present invention involves well-defined preheating, soaking, and controlled cool-down steps. Consequently, the reflow involved in the present invention causes the depositions to traverse a much less drastic thermal gradient to effect reflow-i.e., from T₂ to T₃ to T₂, rather than from T₁ to T₃ to T₁.

The approach of the present invention thus provides several advantages not present in conventional laser soldering. First, the less drastic thermal gradient mentioned above lends itself to the use of lower melting point substrate materials than could be used in conventional laser soldering. Second, this less severe thermal gradient helps form bonding compound joints that are more robust and more consistent. Third, the use of the preheat and soak zones of the present invention allows flux (which may be part of the solder paste, or may be separately applied to the mounting pads) to have more time to do its job of cleaning the metal surfaces of the mounting pads and terminations, removing and preventing oxide formations, and assisting in thermal transfer. And fourth, the smaller thermal gradient allows the use of a lower wattage laser as compared with conventional laser soldering.

The present invention also offers advantages over conventional reflow ovens. One such advantage is that lower melting point substrate materials may be used. This offers increased design flexibility and reduced material costs. Another advantage is that the present invention can be used with both conventional (e.g., FR-4) and lower melting point substrate materials. A further advantage is that the reflow of solder (or activation of thermal-cure adhesive) in the reflow process 203 of the present invention may be performed much quicker than can typically.be done using the conventional reflow process. This is because the selective heating and resultant joint formation may be accomplished much faster than passing the entire PCB assembly through the reflow region 103 of a conventional reflow oven.

One having skill in the art to which the present invention pertains will recognise that the word "reflow", as used herein, may mean (1) simply melting/activating a deposition, or (2) the entire process of melting/activating a deposition, causing/allowing the deposition to flow across the mounting pad on which it sits, and solidifying/curing the deposition into a solid joint connecting a component termination and its respective solder pad. Moreover, those skilled in the art will appreciate that the time scale and specific temperatures T₁ through T₄ that characterise the time-temperature profile disclosed herein will vary from case to case, depending on the substrate materials, bonding compound characteristics (e.g., T_{M}), component layout densities, and other factors. These factors may be used to determine T₁ through T₄ for each specific case, as well as for determining the rates at which to pre-heat and cool down the assembly, the length of time to soak the assembly, the amounts and rates of thermal energy needed to heat the depositions from T₂ to T₃, etc. (Methods for determining these characteristics are well known in the art.)

Various other modifications to the present invention will, no doubt, occur to those skilled in the art to which the present invention pertains. For example, note that although FIGS. 1 and 2 show their respective temperature profiles as being distinct lines, those skilled in the art will appreciate that not all locations on the PCB will follow this precise curve, but may be slightly higher or lower in temperature at any given point in time. Thus, FIGS. 1 and 2 represent "average" temperatures for a typical PCB. It is the following claims which define the scope of the invention.

## Claims

1. A method for reflowing bonding compound on an electronic assembly, in which the assembly includes bonding compound depositions atop mounting pads on a substrate and at least one electronic component having terminations arranged such that each termination rests atop a respective mounting pad, comprising the steps of:
providing said assembly;
locating said assembly in a reflow oven;
preheating said assembly from a first predetermined temperature to a second predetermined temperature;
soaking said assembly at substantially said second predetermined temperature;
selectively heating each bonding compound deposition to a third predetermined temperature above one of a melting point and an activation point of said depositions while maintaining said substrate at substantially said second temperature;
such selective heating being accomplished by focusing a non-contact laser, xenon light or other thermal energy source either directly at a deposition or indirectly at a component termination; and
cooling said assembly to a fourth predetermined temperature below said second temperature.

2. A method according to claim 1, wherein said substrate is constructed of a material having a critical temperature lower than said third predetermined temperature.

3. A method according to claim 2, wherein said critical temperature is one of a melting point, a structural deformation point, and a thermal degradation point of said substrate material.

4. A method according to any one of the preceding claims, wherein at least one of said first and fourth predetermined temperatures is ambient.

5. A method according to any one of the preceding claims, wherein said fourth predetermined temperature is approximately equal to said first predetermined temperature.

6. A method according to any one of the preceding claims, wherein during said selectively heating step said substrate is maintained at a temperature below said third temperature.

7. A method according to any one of the preceding . claims, wherein said bonding compound is a solder having a melting point lower than the third predetermined temperature.

8. A method according to claim 7, wherein said selective heating step melts and reflows each deposition so as to form a solder joint connecting each termination with its respective mounting pad.

9. A method according to any one of claims 1 to 6, wherein said bonding compound is a thermal-cure electrically conductive adhesive having an activation point.

10. A method according to claim 9, wherein said selective heating step activates and reflows each deposition so as to form an electrically conductive adhesive joint connecting each termination with its respective mounting pad.

11. A method according to any one of the preceding claims, wherein said selective heating is achieved using a diode laser.

12. A method as claimed in claim 11, wherein said diode laser is operated in the frequency range of 900 to 950 nm.

13. A method as claimed in any one of the preceding claims wherein said selective heating involves selectively focusing and directing heating energy from said thermal energy source onto each deposition.

14. A method as claimed in any one of the preceding claims, wherein the heating from the thermal energy source is delivered in intermittent bursts.

15. A method as claimed in any one of the preceding claims excluding claim 13 wherein masking is provided so that substantially only one or more depositions is/are exposed to heating from the thermal energy source.

16. An apparatus for reflowing bonding compound on an electronic assembly, in which the assembly includes bonding compound depositions atop mounting pads on a substrate and at least one electronic component having terminations arranged such that each termination rests atop a respective mounting pad, comprising:
a reflow oven;
said reflow oven providing means for preheating said assembly from a first predetermined temperature to a second predetermined temperature;
said reflow oven providing means for soaking said assembly at substantially said second predetermined temperature;
means for selectively heating each bonding compound deposition to a third predetermined temperature above one of a melting point and an activation point of said depositions while maintaining said substrate at said second temperature;
said selective heating means comprising a non-contact laser, xenon light or other thermal energy source; and
means for cooling said assembly to a fourth predetermined temperature below said second temperature.

17. An apparatus as claimed in claim 16, wherein said selective heating means comprises a diode laser adapted to operate in the frequency range 900 to 950 nm.

18. An apparatus as claimed in either claim 16 or. claim 17, wherein said means for selective heating further comprises means for selectively focusing and directing heating energy from said thermal energy source onto each deposition.

19. An apparatus as claimed in any one of claims 16 to 18, wherein said means for selective heating further comprises means for delivering heating energy from said thermal energy source in intermittent bursts.

20. An apparatus according to anyone of claims 16 to 19, further comprising means for masking said assembly such that substantially only one or more depositions is/are exposed to heating energy when said means for selective heating is activated.

## Patentansprüche

1. Ein Verfahren zum Verlaufen einer Haftmischung oder Verbindungsmischung auf einem Elektronikaufbau, in welchem der Aufbau Haftmlschungs-Ablagerungen auf Montageinseln auf einem Substrat und mindestens ein elektronisches Bauteil einschließt, das derart angeordnete Anschlüsse besitzt, daß jeder Anschluß auf einer entsprechenden Montageinsel ruht; welches die Schritte umfaßt:
Bereitstellen dieses Aufbaus;
Plazieren dieses Aufbaus in einem Schmelzofen;
Vorheizen dieses Aufbaus von einer ersten vorherbestimmten Temperatur auf eine zweite vorherbestimmte Temperatur;
Durchwärmen dieses Aufbaus bei im wesentlichen dieser zweiten vorherbestimmten Temperatur;
selektives Aufheizen jeder Haftmischungs-Ablagerung über jeweils einen Schmelzpunkt oder einen Aktivierungspunkt dieser Ablagerung hinaus, während dieses Substrat im wesentlichen bei dieser zweiten Temperatur gehalten wird;
wobei ein derartiges Aufheizen erreicht wird, indem ein kontaktfreier Laser, Xenon-Licht oder eine andere Wärmeenergiequelle entweder direkt auf die Ablagerung oder indirekt auf einen Bauteilanschluß fokussiert wird; und
Kühlen dieses Aufbaus auf eine vierte vorherbestimmte Temperatur unterhalb dieser zweiten Temperatur.

2. Ein Verfahren gemäß Anspruch 1, in dem dieses Substrat aus einem Material konstruiert ist das eine kritische Temperatur aufweist die niedriger ist als diese dritte vorherbestimmte Temperatur.

3. Ein Verfahren gemäß Anspruch 2, in dem diese kritische Temperatur entweder ein Schmelzpunkt, ein Punkt der strukturellen Verformung oder ein Punkt der thermischen Zersetzung dieses Substratmaterials ist.

4. Ein Verfahren gemäß einem der vorstehenden Ansprüche, in dem mindestens eine dieser ersten und vierten vorherbestimmten Temperaturen Umgebungstemperatur ist.

5. Ein Verfahren gemäß einem der vorstehenden Ansprüche, in dem diese vierte vorherbestimmte Temperatur ungefähr gleich der ersten vorherbestimmten Temperatur ist.

6. Ein Verfahren gemäß einem der vorstehenden Ansprüche, in dem während dieses Schrittes des selektiven Aufheizens dieses Substrat bei einer Temperatur unterhalb dieser dritten Temperatur gehalten wird.

7. Ein Verfahren gemäß einem der vorstehenden Ansprüche,in dem diese Haftmischung ein Lot ist, das einen Schmelzpunkt besitzt der niedriger ist als die dritte vorherbestimmte Temperatur.

8. Ein Verfahren gemäß Anspruch 7, in dem dieser selektive Aufheizschritt jede Ablagerung schmilzt und verlaufen läßt, um eine jeden Anschluß mit seiner entsprechenden Montageinsel verbindende Lötstelle zu bilden.

9. Ein Verfahren gemäß einem der Ansprüche 1-6, in dem diese Haftmischung ein wärmehärtender, elektrisch leitfähiger Klebstoff ist, der einen Aktivierungspunkt aufweist.

10. Ein Verfahren gemäß Anspruch 9, in dem dieser selektive Aufheizschritt jede Ablagerung aktiviert und verlaufen läßt, um eine jeden Anschluß mit seiner entsprechenden Montageinsel verbindende elektrisch leitfähige Klebestelle zu bilden.

11. Ein Verfahren gemäß einem der vorstehenden Ansprüche, in dem dieses selektive Aufheizen unter Verwendung eines Diodenlasers erreicht wird.

12. Ein Verfahren gemäß Anspruch 11, in dem dieser Diodenlaser im Frequenzbereich von 900 bis 950 nm betrieben wird.

13. Ein Verfahren gemäß einem der vorstehenden Ansprüche, in dem dieses selektive Aufheizen es beinhaltet, Heizenergie von dieser Wärmeenergiequelle selektiv auf jede Ablagerung zu fokussieren und zu lenken.

14. Ein Verfahren gemäß einem der vorstehenden Ansprüche, in dem das Aufheizen durch die Wärmeenergiequelle in periodisch auftretenden Pulsen erfolgt.

15. Ein Verfahren gemäß einem der vorstehenden Ansprüche ausschließlich Anspruch 13, in dem eine Abdeckung bereitgestellt wird, so daß im wesentlichen eine oder mehrere Ablagerungen der Erhitzung durch die Wärmeenergiequelle ausgesetzt ist/sind.

16. Ein Apparat zum Verlaufen einer Haftmischung oder Verbindungsmischung auf einem elektronsischen Aufbau, in welchem der Aufbau Haftmischungs-Ablagerungen auf Montageinseln auf einem Substrat und mindestens ein elektronisches Bauteil einschließt, das derart angeordnete Anschlüsse besitzt daß jeder Anschluß auf einer entsprechenden Montageinsel ruht; welcher umfaßt:
einen Schmelzofen; wobei
dieser Schmelzofen Vorrichtungen zum Vorheizen dieses Aufbaus von einer ersten vorherbestimmten Temperatur auf eine zweite vorherbestimmte Temperatur bereitstellt;
dieser Schmelzofen Vorrichtungen zum Durchwärmen dieses Aufbaus bei im wesentlichen dieser zweiten Temperatur bereitstellt; sowie
Vorrichtungen zum selektiven Aufheizen jeder Haftmischungs-Ablagerung auf eine dritte vorherbestimmte Temperatur oberhalb jeweils eines Schmelzpunktes oder Aktivierungspunktes dieser Ablagerungen, während dieses Substrat bei dieser zweiten Temperatur gehalten wird; wobei
dieses selektive Aufheizvorrichtungen einen kontaktfreien Laser, Xenon-Licht oder eine andere Wärmeenergiequelle umfassen; und
Vorrichtungen zum Abkühlen dieses Aufbaus auf eine vierte vorherbestimmte Temperatur unterhalb dieser zweiten Temperatur.

17. Ein Apparat gemäß Anspruch 16, in dem diese selektive Aufheizvorrichtung einen Diodenlaser umfaßt, der angepaßt ist um in einem Frequenzbereich von 900 bis 950 nm zu arbeiten.

18. Ein Apparat gemäß entweder Anspruch 16 oder Anspruch 17, in dem diese Vorrichtung zum selektiven Aufheizen weiterhin Vorrichtungen umfaßt, um Heizenergie von dieser Wärmeenergiequelle selektiv auf jede Ablagerung zu fokussieren und zu lenken.

19. Ein Apparat gemäß einem der Ansprüche 16 bis 18, in dem diese Vorrichtung zum selektiven Aufheizen weiterhin Vorrichtungen umfaßt, um Heizenergie von dieser Wärmeenergiequelle in periodischen Pulsen zu liefern.

20. Ein Apparat im Einklang mit einem der Ansprüche 16 bis 19, der weiterhin Vorrichtungen umfaßt um diesen Aufbau derart zu maskieren, daß im wesentlichen nur eine oder mehrere Ablagerungen der Heizenergie ausgesetzt sind, wenn diese Vorrichtung zur selektiven Beheizung aktiviert ist.

## Revendications

1. Procédé destiné à une refusion d'un composé de connexion sur un montage électronique, dans lequel le montage comprend des dépôts de composé de connexion au-dessus de pastilles de montage sur un substrat et au moins un composant électronique comportant des terminaisons agencées de telle sorte que chaque terminaison repose au-dessus d'une pastille de montage respective, comprenant les étapes consistant à :
fournir ledit montage,
placer ledit montage dans un four de refusion,
préchauffer ledit montage à partir d'une première température prédéterminée jusqu'à une seconde température prédéterminée,
tremper ledit montage pratiquement à ladite seconde température prédéterminée,
chauffer sélectivement chaque dépôt de composé de connexion à une troisième température prédéterminée au-dessus de l'un d'un point de fusion et d'un point d'activation desdits dépôts tout en maintenant ledit substrat pratiquement à ladite seconde température,
un tel chauffage sélectif étant réalisé en focalisant une source d'énergie sans contact à laser, à lumière au xénon ou autre source d'énergie thermique soit directement sur un dépôt soit indirectement sur une terminaison de composant, et
en refroidissant ledit montage jusqu'à une quatrième température prédéterminée en-dessous de ladite seconde température.

2. Procédé selon la revendication 1, dans lequel ledit substrat est construit à partir d'un matériau présentant une température critique inférieure à ladite troisième température prédéterminée.

3. Procédé selon la revendication 2, dans lequel ladite température critique est une température parmi un point de fusion, un point de déformation structurelle, et un point de dégradation thermique dudit matériau de substrat.

4. Procédé selon l'une quelconque des revendications précédentes, dans lequel au moins l'une desdites première et quatrième températures prédéterminées est la température ambiante.

5. Procédé selon l'une quelconque des revendications précédentes, dans lequel ladite quatrième température prédéterminée est approximativement égale à ladite première température prédéterminée.

6. Procédé selon l'une quelconque des revendications précédentes, dans lequel durant ladite étape de chauffage sélectif, ledit substrat est maintenu à une température en-dessous de ladite troisième température.

7. Procédé selon l'une quelconque des revendications précédentes, dans lequel ledit composé de connexion est une soudure présentant un point de fusion inférieur à la troisième température prédéterminée.

8. Procédé selon la revendication 7, dans lequel ladite étape de chauffage sélectif fait fondre et exécute une refusion de chaque dépôt de façon à former une jonction de soudure connectant chaque terminaison avec sa pastille de montage respective.

9. Procédé selon l'une quelconque des revendications 1 à 6, dans lequel ledit composé de connexion est un adhésif électriquement conducteur à cuisson thermique présentant un point d'activation.

10. Procédé selon la revendication 9, dans lequel ladite étape de chauffage sélectif active et exécute une refusion de chaque dépôt de façon à former une jonction d'un adhésif électriquement conducteur connectant chaque terminaison avec sa pastille de montage respective.

11. Procédé selon l'une quelconque des revendications précédentes, dans lequel ledit chauffage sélectif est obtenu en utilisant un laser à diode.

12. Procédé selon la revendication 11, dans lequel ledit laser à diode est mis en oeuvre dans la plage de fréquences de 900 à 950 nm.

13. Procédé selon l'une quelconque des revendications précédentes, dans lequel ledit chauffage sélectif implique une focalisation et une orientation sélectives de l'énergie de chauffage depuis ladite source d'énergie thermique sur chaque dépôt.

14. Procédé selon l'une quelconque des revendications précédentes, dans lequel le chauffage provenant de la source d'énergie thermique est délivré par salves intermittentes.

15. Procédé selon l'une quelconque des revendications précédentes, à l'exclusion de la revendication 13, dans lequel un masquage est prévu de manière à ce que pratiquement seulement un ou plusieurs dépôts soit/soient exposés à un chauffage provenant de la source d'énergie thermique.

16. Dispositif destiné à un composé de connexion par refusion sur un montage électronique, dans lequel le montage comprend des dépôts de composé de connexion au-dessus de pastilles de montage sur un substrat et au moins un composant électronique comportant des terminaisons agencées de telle sorte que chaque terminaison repose au-dessus d'une pastille de montage respective, comprenant :
un four de refusion,
ledit four de refusion fournissant un moyen destiné à préchauffer ledit montage à partir d'une première température prédéterminée jusqu'à une seconde température prédéterminée,
ledit four de refusion fournissant un moyen destiné à tremper ledit montage à pratiquement ladite seconde température prédéterminée,
un moyen destiné à chauffer sélectivement chaque dépôt de composé de connexion à une troisième température prédéterminée au-dessus de l'un d'un point de fusion et d'un point d'activation desdits dépôts tout en maintenant ledit substrat à ladite seconde température,
ledit moyen de chauffage sélectif comprenant un laser sans contact, une lumière au xénon et ou une autre source d'énergie thermique, et
un moyen destiné à refroidir ledit montage à une quatrième température prédéterminée en-dessous de ladite seconde température.

17. Dispositif selon la revendication 16, dans lequel ledit moyen de chauffage sélectif comprend un laser à diode conçu pour fonctionner dans la plage de fréquences de 900 à 950 nm.

18. Dispositif selon soit la revendication 16 soit la revendication 17, dans lequel ledit moyen destiné à un chauffage sélectif comprend en outre un moyen destiné à focaliser et à orienter sélectivement une énergie de chauffage depuis ladite source d'énergie thermique jusque sur chaque dépôt.

19. Dispositif selon l'une quelconque des revendications 16 à 18, dans lequel ledit moyen destiné à un chauffage sélectif comprend en outre un moyen destiné à délivrer une énergie de chauffage depuis ladite source d'énergie thermique par salves intermittentes.

20. Dispositif selon l'une quelconque des revendications 16 à 19, comprenant en outre un moyen destiné à masquer ledit montage de sorte que pratiquement seulement un ou plusieurs dépôts et/sont exposés à une énergie de chauffage lorsque ledit moyen destiné à un chauffage sélectif est activé.
